Europäisches Patentamt

European Patent Office

Office européen des brevets

(19)

(11) **EP 0 918 999 B1**

(12) **EUROPÄISCHE PATENTSCHRIFT**

(45) Veröffentlichungstag und Bekanntmachung des Hinweises auf die Patenterteilung:
**10.11.2004 Patentblatt 2004/46**

(21) Anmeldenummer: **97936588.9**

(22) Anmeldetag: **04.08.1997**

(51) Int Cl.$^7$: **G01R 33/12**

(86) Internationale Anmeldenummer:
**PCT/DE1997/001638**

(87) Internationale Veröffentlichungsnummer:
**WO 1998/005976 (12.02.1998 Gazette 1998/06)**

(54) **VERFAHREN UND VORRICHTUNG ZUR ZERSTÖRUNGSFREIEN ERMITTLUNG VON MATERIALPARAMETERN VON FERROMAGNETISCHEN WERKSTOFFEN**

NON-DESTRUCTIVE PROCESS AND DEVICE FOR DETERMINING THE PARAMETERS OF FERROMAGNETIC MATERIALS

PROCEDE ET DISPOSITIF DE DETERMINATION NON-DESTRUCTIVE DES PARAMETRES DE MATERIAUX FERROMAGNETIQUES

(84) Benannte Vertragsstaaten:
**CH DE FR GB LI NL**

(30) Priorität: **02.08.1996 DE 19631311**

(43) Veröffentlichungstag der Anmeldung:
**02.06.1999 Patentblatt 1999/22**

(73) Patentinhaber: **Fraunhofer-Gesellschaft zur Förderung der angewandten Forschung e.V. 80686 München (DE)**

(72) Erfinder:
• **MEYENDORF, Norbert D-66482 Zweibrücken (DE)**
• **RÖSNER, Henrik D-66793 Saarwellingen (DE)**

(74) Vertreter: **Rösler, Uwe, Dipl.-Phys. Rösler Patentanwaltskanzlei, Landsberger Strasse 480a 81241 München (DE)**

(56) Entgegenhaltungen:
**WO-A-92/18839          US-A- 4 352 065
US-A- 5 565 773**

• **MIZUTANI M ET AL: "DISTANCE SENSORS UTILIZING A CURRENT-EXCITING LARGE BARKHAUSEN EFFECT IN TWISTED AMORPHOUS MAGNETOSTRICTIVE WIRES" IEEE TRANSLATION JOURNAL ON MAGNETICS IN JAPAN, Bd. 9, Nr. 2, 1.März 1994, Seiten 102-108, XP000489672**

**Beschreibung**

**Technisches Gebiet**

Die Erfindung betrifft ein Verfahren und eine Vorrichtung zur zerstörungsfreien Ermittlung von Materialparametern von ferromagnetischen Werkstoffen durch Auswertung des sog. Barkhausen-Effekts bzw. des sog. Barkhausen-Rauschens gemäß dem Oberbegriff des Anspruchs 1 bzw. Anspruch 6.

**Stand der Technik**

Die Eigenschaften ferromagnetischer Materialien können u.a. durch mikromagnetische Verfahren ermittelt werden. Das Prinzip dieser Verfahren basiert darauf, daß bei periodischer Ummagnetisierung eines Ferromagneten die magnetische Domänenstruktur kontinuierlich verändert wird. Begrenzungen zwischen Bereichen gleicher Magnetisierung heißen Blochwände. Diese Blochwände bewegen sich bei Magnetisierungsänderungen durch das Werkstoffgefüge und treten mit der Mikrostruktur des Werkstoffes in Wechselwirkung. Diese Wechselwirkung läßt sich als elektromagnetisches Signal, das sog. Barkhausenrauschen, mit einem geeigneten Sensor empfangen.

Durch Auswertung des Barkhausenrauschsignales in Abhängigkeit von der anliegenden Magnetfeldstärke werden Informationen über die Mikrostruktur des Werkstoffes sowie bestimmte Werkstoffeigenschaften erhalten:

Insbesondere reagiert das magnetische Barkhausenrauschen empfindlich auf Eigenspannungen im Werkstoff. Wie Untersuchungen bei Variation der Richtung des magnetischen Feldes gezeigt haben, wird bei Eigenspannungen bevorzugt die Spannungskomponente in Magnetisierungsrichtung erhalten. Es sind Vorrichtungen zur Eigenspannungsmessung auf Basis des Barkhausenrauschens in der Anwendung.

Teilweise werden auch andere mikromagnetische Wechselwirkungen ausgenutzt, wie beispielsweise die Messung der Überlagerungspermeabilität, die Analyse von Oberwellen und die dynamische Magnetostriktion.

Beispielsweise aus der DE 43 43 225 C1, der EP 683 393 A1 oder dem Artikel "Using the Barkhausen Effect to Determine the Easy Axis of Magnetization in Steels" von A. Dhar, C. Jagadish und D.L. Atherton, erschienen in Materials Evaluation. 1992, S. 1139 bis 1141 sind verschiedene Verfahren und Vorrichtungen zur Ermittlung von Materialparametern, wie Gefüge, Eigenspannungen, Lage der Magnetisierungsachsen etc. bekannt, von denen bei der Formulierung des Oberbegriffs des Patentanspruchs 1 ausgegangen wird. Auf diese Druckschriften wird im übrigen zur Erläuterung aller hier nicht näher erläuterten Einzelheiten ausdrücklich verwiesen.

All diesen Verfahren ist gemeinsam, daß über ein magnetisches Joch ein sich periodisch veränderndes Magnetfeld erzeugt, und durch eine Spule auf der Oberfläche des zu prüfenden Teiles das Barkhausenrauschen empfangen wird. Ergänzend hierzu wird eine Hallsonde zur Messung der tangentialen Feldstärke eingesetzt. Diese Feldstärkemessung dient zum einen der Ermittlung des Zeitverlaufes der Tangentialfeldstärke, zum anderen wird hieraus eine Information für eine Feldstärkeregelung abgeleitet. Von besonderer Bedeutung ist, daß die Hallsonde zur Tangentialfeldstärkemessung in der Mitte, zwischen den Polschuhen eines Erregerjoches, angeordnet werden muß, da nur an dieser Stelle eine zusätzlich auftretende Normalkomponente verschwindet.

Damit ist eine feste Sensorgeometrie, bestehend aus Magnetisierungsjoch und Sensorelement, erforderlich, die den Einsatzbereich der Vorrichtung einschränkt. Darüberhinaus ist aufgrund von auftretenden Streufeldern, insbesondere am Kopplungsbereich zwischen Joch und Prüfteil, eine Verfälschung der Messung möglich. Nachteilig beim Stand der Technik sind beispielsweise schwierig oder nicht realisierbare Ummagnetisierungsrichtungen zur Erzeugung des Barkhausen-Effektes bei bestimmten Bauteilgeometrien, wie z.B. eine rotationssymmetrische Feldstärke in Umfangsrichtung von zylindrischen Prüfteilen. Weiterhin ergeben sich in bestimmten Anwendungsfällen Schwierigkeiten bei der magnetischen Ankopplung. Außerdem entstehen Streufelder und entmagnetisierende Felder. Auch ist die Feldstärkebestimmung mittels Hallsonde oft ungenau. Oftmals beeinflussen auch die Materialeigenschaften des Jochkerns und des zu prüfenden Bauteils die Messung, z.B. bei der Oberwellenanalyse.

In der US 5,657,773 ist eine gattungsgemäße Messanordnung beschrieben, die sowohl über eine Erreger- als auch über eine Detektionseinheit verfügt, wobei die Erregereinheit ein magnetisches Wechselfeld erzeugt, das innerhalb des Prüfkörpers das mit der Detektionseinheit messbare Barkhausen-Rauschen hervorruft. Die Erregereinheit weist einen U-förmigen, metallischen Kem auf, um dessen Joch eine Erregerspule gewickelt ist und dessen beide Endflächen derart angeordnet sind, dass zwischen den Endflächen und dem Prüfkörper ein Spalt gebildet wird. Die Detektionseinheit ist zwischen den Schenkeln des Jochs, ebenfalls beabstandet zum Prüfkörper, angeordnet. Hierbei ist für eine zuverlässige Detektion der magnetischen Eigenschaften eines Prüfkörpers eine exakte Positionierung der einzelnen Komponenten der Messanordnung von großer Bedeutung ist.

Schließlich ist in dem Artikel von Mizutani M. et al.: Distance sensors utilizing a current-exciting large Barkhausen effect in twisted amorphous magnetostrictive wires, IEEE Translation Journal on Magnetics in Japan, Vol. 9, No. 2, 1. März 1994, Seiten 102 bis 108, ein Sensor zur Abstandsdsmessung beschrieben, der einen Stromkreis aufweist, in dem ein Spannungsgenerator, ein Verstärker, ein ohmscher Widerstand, eine

Spule $C_0$, sowie ein amorpher Draht in Reihe geschaltet sind. Sobald der Spannungsgenerator eine Wechselspannung erzeugt, wird durch die stromdurchflossene Spule $C_0$ ein magnetisches Feld im Draht induziert. Weiterhin sind zwei Spulen $C_1$ und $C_2$ vorgesehen, von denen eine derart parallel zum Draht verschieblich gelagert ist, dass die beiden Spulen eine parallel zum Draht verlaufende Messstrecke X, deren Länge veränderlich ist, einschließen. Durch das in dem Draht angeregte magnetische Wechselfeld werden in den Spulen $C_1$ und $C_2$ in einem zeitlichen Abstand $\tau$ jeweils Spannungspeaks angeregt. Unter Berücksichtigung der zeitlichen Änderung des magnetischen Wechselfelds, insbesondere der Ausbreitungsgeschwindigkeit längs des Drahtes, wird der zeitliche Abstand $\tau$ der Spannungspeaks ausgewertet und die Länge der Messstrecke X, ermittelt. Somit stellt der Abstand zwischen den beiden Spulen $C_1$ und $C_2$ die zu ermittelnde Messgröße, also bspw. die Länge eines zwischen den beiden Spulen angeordneten Prüfkörpers, dar.

**Darstellung der Erfindung**

Aufgabe der Erfindung ist es, ein Verfahren und eine Vorrichtung zur zerstörungsfreien Ermittlung von Materialparametern von ferromagnetischen Werkstoffen durch Auswertung des sog. Barkhausen-Effekts bzw. des sog. Barkhausen-Rauschens derart weiterzubilden, daß bei nahezu beliebiger Bauteilgeometrie das Barkhausenrauschen leicht angeregt und ausgewertet werden kann.

Eine erfindungsgemäße Lösung dieser Aufgabe ist im Patentanspruch 1 bzw 6 gekennzeichnet. Weiterbildungen der Erfindung sind Gegenstand der abhängigen Ansprüche.

Erfindungsgemäß wird das Barkhausenrauschen nicht mittels eines externen magnetischen Jochs, sondern mittels elektrischer Stromdurchflutung angeregt. Mit zwei Elektroden wird über das zu prüfende Teil (Prüfkörper) ein elektrischer Stromkreis geschlossen. Je nach dem magnetischen Verhalten des Werkstoffes und insbesondere der notwendigen magnetischen Feldstärke bis zur Sättigung sowie der Querschnittsfläche des Prüfteils senkrecht zur Stromflußrichtung wird eine entsprechend hohe, zeitlich periodische Stromstärke gewählt, so daß eine ausreichende Stromdichte erzeugt werden kann. Die zeitlich periodische, rotationssymmetrische Feldstärke um die Stromflußrichtung erzeugt die zum Barkhausen-Effekt notwendigen Ummagnetisierungsvorgänge.

Mit der Erfindung wird z.B. die Bestimmung der Eigenspannungen in Umfangsrichtung bei rotationssymmetrischen Prüfkörpern mit Hilfe des Barkhausen-Effektes über die Erzeugung einer rotationssymmetrischen Feldstärke sehr vereinfacht. Die Streufelder und entmagnetisierende Felder werden in dem Ausmaß wie bei der Jochanregung vermieden, auch ist man unabhängiger bei der Positionierung des Sensors in Bezug auf die Plazierung der Elektroden. In bestimmten Fällen kann die Magnetisierungsvorrichtung einfacher gestaltet werden. Besonders vorteilhaft ist die numerische Berechenbarkeit der magnetischen Feldstärke an einfachen Bauteilgeometrien (zylindrische Prüfteile, plattenförmige Prüfteile).

Durch die Erfindung erreicht man u.a. folgende Vorteile gegenüber dem Stand der Technik:

- Es ist nicht erforderlich, zur Bestimmung der magnetischen Feldstärke im Prüfkörper eine Hallsonde bei der Aufnahme der Barkhausenrauschprofilkurve zu verwenden, da aufgrund der Prüfkörper-Geometrie beispielsweise bei rotations-symmetrischen Prüfkörpern das Magnetfeld berechnet werden kann.

- Durch den Verzicht auf die Hallsonde ist eine Verkleinerung des Prüfkopfes und Verminderung des Meßaufwandes möglich.

- Bei weichmagnetischen Prüfkörpern und Prüfkörpern geringen Querschnittes wird die Magnetisierungsvorrichtung zur Anregung des Barkhausen-Effektes vereinfacht.

- Weiterhin werden Streufelder und entmagnetisierende Felder vermieden, die über die magnetische Ankopplung bei der Polmagnetisierung entstehen und eine nur ungenaue Feldstärkebestimmung mittels Hallsonde auf der Prüfteiloberfläche zulassen.

- Darüberhinaus kann der Barkhausen-Effekt zur Werkstoffcharakterisierung gleichzeitig mit anderen Meßverfahren genutzt werden, bei denen hohe elektrische Stromdichten zur Werkstoffprüfung eingesetzt werden; derartige Meßverfahren sind beispielsweise die magnetische Oberflächenrißprüfung.

Das erfindungsgemäße Verfahren unterscheidet sich dabei von herkömmlichen Verfahren, da der durch direkten Stromdurchgang erzeugte Barkhausen-Effekt von demjenigen, der bei der Jochmagnetisierung erzeugt wird, zu unterscheiden ist:

Es werden in beiden Fällen bei demselben Werkstoffzustand andere Barkhausenrauschprofilkurven gemessen. Hierfür sind mehrere Gründe denkbar:

- Bei der direkten Stromdurchflutung der Probe werden um die Stromflußrichtung magnetische Wirbelfelder erzeugt, wobei zusätzlich Ohm'sche Wärme durch die Wechselwirkung der Leitungselektronen mit dem Metallgitter umgesetzt wird. Diese Wärme stellt dann eine zusätzliche thermische Anregung dar, die die Beweglichkeit der Blochwände erhöht und somit eine andere Rauschdynamik bewirkt.

- Darüber hinaus ist auch eine Wechselwirkung der fließenden Leitungselektronen mit den Blochwänden während der Ummagnetisierungsvorgänge nicht auszuschließen.

- Einen weiteren Grund könnten die kreisförmig angeordneten, sich innerhalb des Probenwerkstoffes schließenden magnetischen Wirbelfelder sein. Aufgrund des fehlenden Überganges der magnetischen Flußlinien in den Luftraum kommt es nicht zur Ausbildung eines streufeldbedingten entmagnetisierenden Feldes in die Umfangsrichtung.

Die Stromdurchflutung des Prüfteils kann grundsätzlich bei allen mikromagnetischen Prüfverfahren (magnetisches und akustisches Barkhausenrauschen, Überlagerungspermeabilität, Oberwellenanalyse, dynamische Magnetostriktion) zum Durchlaufen der ferromagnetischen Hysterese genutzt werden.

**Kurze Beschreibung der Zeichnung:**

Die Erfindung wird nachstehend anhand von Ausführungsbeispielen unter Bezugnahme auf die Zeichnung näher beschrieben, in der zeigen:

Fig. 1    ein ersten Ausführungsbeispiel der Erfindung,
Fig. 2    ein zweites Ausführungsbeispiel,
Fig. 3a   eine Anordnung mit einer spitzenförmigen Elektrode,
Fig. 3b   unterschiedliche Sensoranordnungen,
Fig. 4    eine Anordnung mit zwei Elektroden, und
Fig. 5    Meßergebnisse.

**Beschreibung bevorzugter Ausführungsbeispiele:**

In den folgenden Figuren sind gleiche Teile mit den selben Bezugszeichen versehen, so daß auf eine erneute Vorstellung verzichtet werden kann. Dabei bezeichnen die Bezugszeichen 1 eine Elektrode, 2 einen Prüfkörper, 3 einen Sensor zur Erfassung des Barkhausen-Rauschens und 4 eine Signalverarbeitungseinheit, an die das Ausgangssignal des Sensors 3 angelegt ist. Der Sensor 3 kann dabei in bekannter Weise, beispielsweise als Spule oder in Art eines Tonbandkopfes oder Videokopfes oder in der aus dem bereits genannten Artikel "Using the Barkhausen Effect.." bekannten Weise aufgebaut sein, so daß auf eine detaillierte Beschreibung des Sensors 3 und der Signalverarbeitungseinheit 4 verzichtet wird.

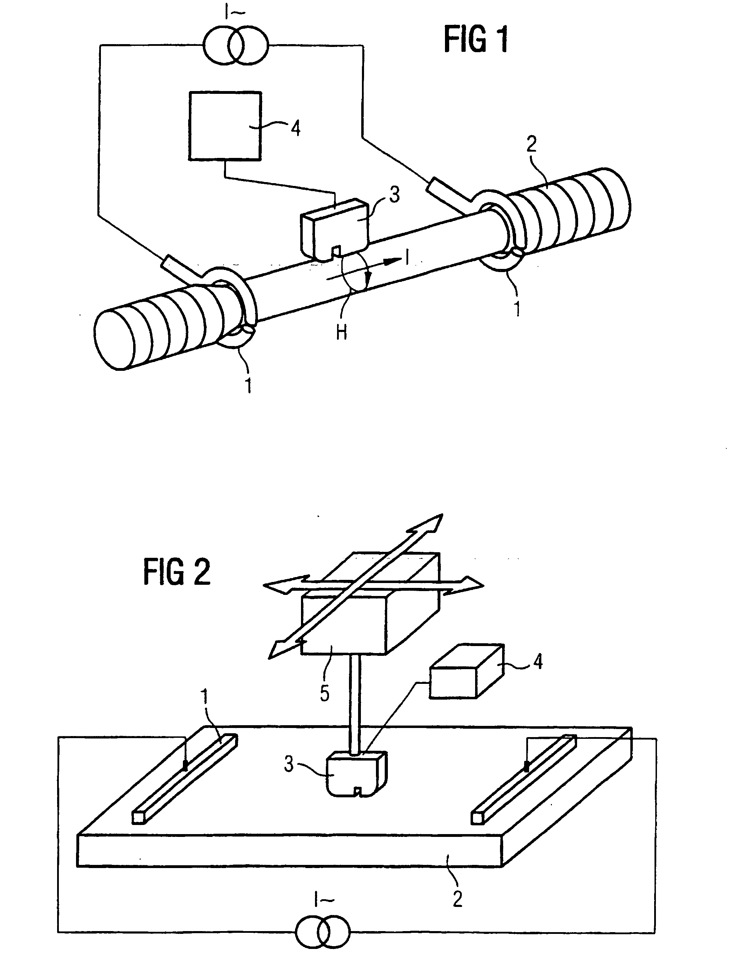

Fig. 1 zeigt eine Anordnung zur Messung des magnetischen Barkhausenrauschens und der Überlagerungspermeabilität an miniaturisierten drahtförmigen Zugproben 2, bei dem gezeigten Ausführungsbeispiel an Feinkornbaustahl 20 MnMoNi 5 5.

Mit Hilfe der am Rand der Probe 2 angeordneten Elektroden 1, die ringförmig am Umfangsrand der Probe anliegen, wird in der Probe 2 ein elektrischer Stromfluß (Pfeil I) erzeugt, durch den ein rotationssymmetrisches Magnetfeld H entsteht. Das so erzeugte magnetische Wirbelfeld ist in die Umfangsrichtung der Probe gerichtet.

Da der zu prüfende Stahl in einem weichmagnetischen Zustand vorliegt (Koerzitivfeldstärke ca. 5 A/cm) und die kreisförmige Querschnittsfläche bei dem gezeigten Ausführungsbeispiel nur A = 3,15 mm² beträgt, ist eine Wechselstromstärke von I = 10 A ausreichend, um im Randbereich der Probe eine magnetische Feldstärke von ca. 13 A/cm zu erzeugen, die eine Sättigungsmagnetisierung ermöglicht. Bei dieser Stromstärke kommt es zu keiner merklichen Temperaturerhöhung, so daß die magnetischen Eigenschaften des Werkstoffes nicht wesentlich verändert werden.

Durch den Bearbeitungsvorgang bedingt sind an diesen drahtförmigen Proben 2 Bearbeitungsspannungen in Umfangsrichtung zu erwarten. Magnetisch werden die Spannungskomponenten vorrangig in der Magnetisierungsrichtung gemessen.

Aus diesem Grunde ist eine Stromdurchflutung, die eine Magnetisierung in der Umfangsrichtung bewirkt, eine geeignetere Anregungsform als die Anregung bei bekannten Verfahren:

Die bisher übliche Magnetisierung mittels eines Jochmagneten ist nur in Probenlängsrichtung möglich und mit einer schwierigen magnetischen Ankopplung der Polschuhe an die kreisförmige Probe verbunden.

Da es für den Fall des stromdurchflossenen Leiters möglich ist, den magnetischen Feldstärkeverlauf innerhalb und außerhalb des Leiters mit Hilfe des Durchflutungsgesetzes zu berechnen, kann auf die relativ unzuverlässige Messmethode der magnetischen Tangentialfeldstärke H mit Hilfe einer Hallsonde auf der Probenoberfläche verzichtet werden.

Innerhalb der Probe gilt für die magnetische Wechselfeldstärke mit der komplexen Darstellung der harmonischen Zeitabhängigkeit durch $e^{+i\omega t}$:

$$H(r) = \frac{I}{2 \cdot \pi \cdot r_0} \frac{J(k \cdot r)}{J(k \cdot r_0)}$$

mit

$$k = \beta - i \cdot \alpha = (1-i)\sqrt{\frac{\omega \cdot \mu_0 \cdot \mu \cdot \sigma}{2}}$$

$J_1$ : Besselsche Funktion der ersten Art und der ersten Ordnung
$r_0$ : Radius des kreisförmigen Leiters
$r$ : Abstand von der Mittelachse
$I$ : Stromstärke
$k$ : Wellenzahl
$\sigma$ : elektrische Leitfähigkeit

μ : relative Permeabilität

$\mu_0$ : Induktionskonstante

i : imaginäre Einheit

α: Dämpfungskonstante

β : Phasenkonstante

ω : Kreisfrequenz ($\omega = 2 \cdot \pi \cdot f$)

f : Frequenz

Zur Ableitung der Formeln wird auf Kupfmüller, Einführung in die theoretische Elektrotechnik; Springer-Verlag, (1968) verwiesen.

Das erfindungsgemäße Verfahren erlaubt insbesondere eine Werkstoffcharakterisierung mittels Barkhausen-Effekt als Erweiterung der magnetischen Oberflächenrißprüfung: Magnetfelder werden zur Ermittlung von Oberflächenrissen eingesetzt. Hierbei kommt es bei geeigneter Magnetisierung des Werkstückes infolge von Permeabilitätsänderungen im Rißbereich zur Entstehung von magnetischen Streufeldern, die dann auf der Prüfteiloberfläche nachgewiesen werden. Die Erzeugung der magnetischen Flußlinien erfolgt mit Polmagnetisierung oder mit Stromdurchflutung, im letzteren Fall fließt ein elektrischer Strom hoher Stromstärke (bis zu I=10000 A) als Gleich-, Halbwellengleich-, Wechselstrom oder Impulsstrom durch das Prüfstück. Hierzu wird auf Heptner, Stroppe: Magnetische und magnetinduktive Werkstoffprüfung; VEB Deutscher Verlag für Grundstoffindustrie, Leipzig (1972) verwiesen.

Das bei der Stromdurchflutung gleichzeitig angeregte Barkhausenrauschen kann mit Hilfe der entsprechenden magnetinduktiven Sensoren (Spule, Tonbandkopf, Videokopf) auf der Werkstückoberfläche detektiert werden und zur Ermittlung von Werkstoffeigenschaften (Eigenspannungen, Gefüge) eingesetzt werden. Somit sind die Prüfgrößen des magnetischen Barkhausenrauschens ohne eine separate Magnetisierungsvorrichtung und an Prüfkörpern, die die Berechnung der magnetischen Feldstärke aus der Stromdichte zulassen, auch ohne Verwendung einer Hallsonde zugänglich.

Fig. 2 zeigt ein Ausführungsbeispiel einer erfindungsgemäßen Vorrichtung, die die Anregung des Barkhausenrauschens in dünnen Schichten erlaubt. Bei diesem Ausführungsbeispiel ist der Barkhausen-Sensor 3 an einem Manipulator 5 angebracht, so daß der Sensor 3 die Oberfläche des Probekörpers 2 abtastet. Der Probekörper 2 besteht bei dem gezeigten Ausführungsbeispiel aus einem nicht leitfähigem Schichtträger für die leitfähige, zu prüfende Schicht.

In der mikromagnetischen Mikroskopie werden unter anderem dünne Schichten mit Hilfe des Barkhausen-Effektes charakterisiert. Hierzu wird auf U. Finkler: Studie dünne Schichten; IzfP-Abschlußbericht Nr.: 940315-E, (1994) verwiesen.

Auch hierbei kann die Stromdurchflutung von Vorteil sein, da die Feldstärkemessung mittels Hallsonde an dünnen Schichten besonders schwierig ist und die Gefahr einer inhomogenen Magnetisierung besteht.

In einer weichmagnetischen dünnen Schicht (Sendust mit der Koerzitivfeldstärke $H_c$= 0,4 A/cm) der Dicke d = 10 μm und Breite b = 3500 μm erzeugt die Wechselstromstärke I = 0,7 A eine Stromdichte j = 2000 A/cm$^2$. Im Oberflächenbereich der dünnen Schicht kann die parallel zur Oberfläche und senkrecht zur Stromflußrichtung gerichtete Feldstärke zu H = j · (d/2) = 1 A/cm abgeschätzt werden. Hierzu wird auf G.Strassacker: Rotation, Divergenz und das Drumherum; Teubner Studienskripten, Stuttgart (1984) verwiesen.

Wesentlich höhere Stromdichten, die bei magnetisch härteren Werkstoffen eingesetzt werden müßten, führen jedoch aufgrund des relativ hohen elektrischen Widerstandes der dünnen Schicht zu einer Erhitzung der Probe bis oberhalb der Curietemperatur.

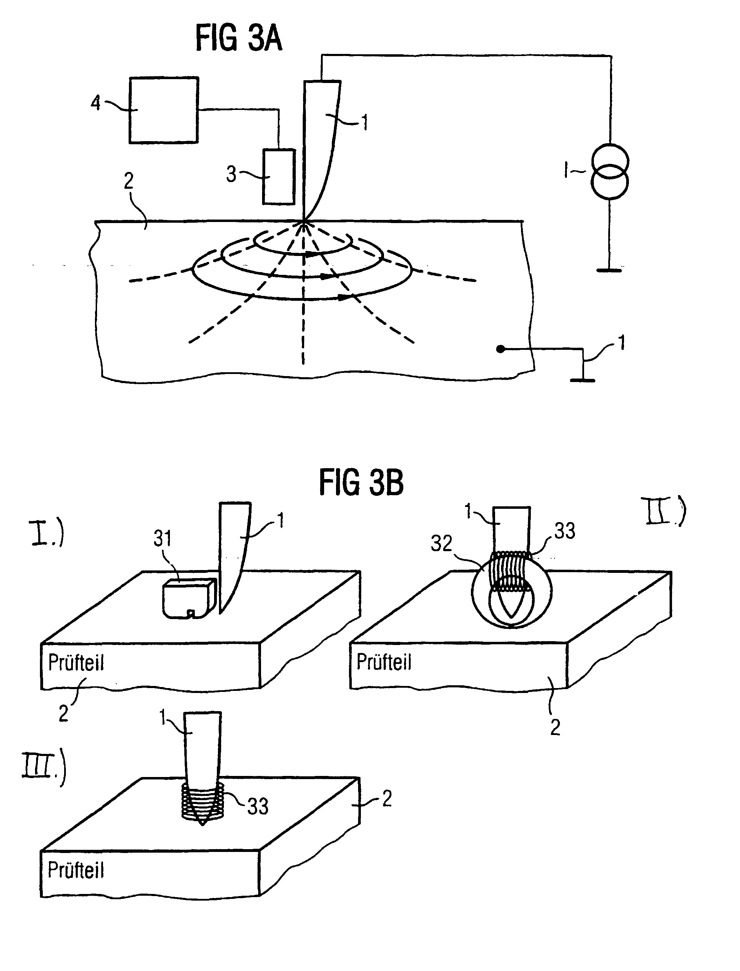

Fig. 3a zeigt die Nutzung des Barkhausen-Effektes im Bereich einer stromdurchfluteten Elektrode, die eine Spitze aufweist:

Im Unterschied zu den vorherigen, in den Fig. 1 und 2 dargestellten Beispielen wird hier ausgenutzt, daß die Stromdichte im Bereich der Strom-Einprägestelle (Kontaktbereich der spitzenförmigen Elektrode 1 mit dem Prüfkörper 2) schon bei geringen Stromstärken so hoch werden kann, daß der Barkhausen-Effekt ausgelöst wird.

Entscheidend ist hierbei die Größe der Kontaktfläche der Elektrode. Bei einer spitzenförmigen Elektrode mit einer geringen Kontaktfläche wird bei einer Stromstärke I von ca. 3 A ein deutlich meßbarer Barkhausen-Effekt erzeugt.

Bei dieser Stromstärke kommt es zu keiner merklichen Temperaturerhöhung, so daß die magnetischen Eigenschaften des Werkstoffes nicht verändert werden.

In Fig. 3a sind gestrichelt die Stromfäden des erregenden Wechselstroms und durchgezogen die Feldlinien des induzierten magnetischen Wechselfeldes eingezeichnet.

In Fig. 3a ist der Sensor 3 im Bereich der spitzenförmigen einen Elektrode 1 positioniert, wobei der Prüfkörper 2 geerdet ist oder auf Gegenpolung liegt.

Fig. 3b zeigt verschiedene Ausbildungen und Anordnungen des Sensors in Bezug auf die spitzenförmige Elektrode 1. Der Sensor kann in Art eines Tonband- oder Videokopfes 31, (Fig 3B I.) als Ferritkern 32 mit einer Spule 33 (Fig 3B II.) oder als Spule 33 ausgebildet sein, die die Elektrode 1 umgibt (Fig 3B III.).

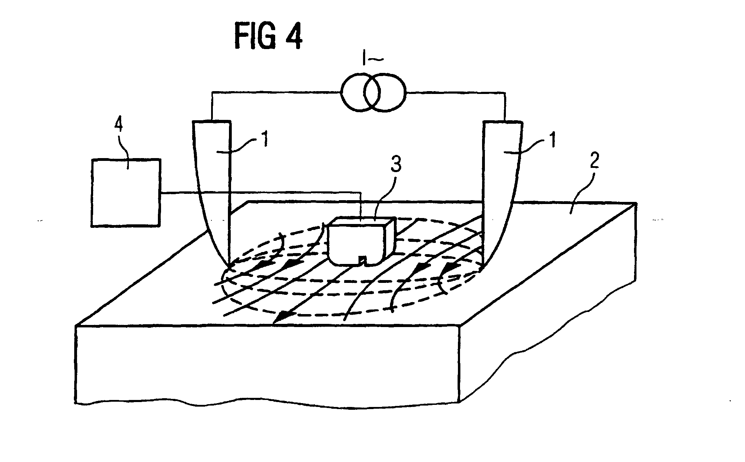

Bei dem in Fig. 4 dargestellen Ausführungsbeispiel sind zwei spitzenförmige Elektroden dicht beieinander angeordnet. Der Sensor befindet sich zwischen zwei eng nebeneinander positionierten Elektroden. Hierdurch kann ein genau definierter Bereich stromdurchflutet werden, da die Position der beiden Elektroden zueinander gleich bleibt. In Fig. 4 sind gestrichelt die Stromfäden des erregenden Wechselstrom und durchgezogen die Feldlinien des induzierten magnetischen Wechselfeldes eingezeichnet.

Die Verteilung der Stromdichte im Kontaktbereich der Elektrode bedingt die Anregung des Barkhausen-Effektes im Bereich des Sensors. Folgende Faktoren spielen hierbei eine entscheidende Rolle:

- Spitzengeometrie,
- Frequenz des Stromes (Erregerfrequenz),
- Amplitude des Stromes.

Da die Kontaktverhältnisse zwischen der Elektrode und dem Prüfteil (Ohmscher Widerstand) an verschiedenen Meßorten variieren können, ist der elektrische Stromkreis stromeingeprägt zu betreiben. Bei einer gegebenen Spitzengeometrie und Erregerfrequenz ist somit die Kontrolle der Stromstärke ausreichend, damit kontrollierte und vergleichbare Anregungsbedingungen gegeben sind. Der Einsatz einer Hallsonde zur Messung der magnetischen Feldstärke ist hierbei nicht erforderlich.

Fig. 5 zeigt Meßergebnisse mit einer erfindungsgemäßen Vorrichtung. An Proben unterschiedlicher Härte sind Barkhausenrauschmessungen mittels des oben beschriebenen Verfahrens durchgeführt worden. In dem oberen Teilbild ist das Barkhausen-Rauschsignal als Funktion des aus dem Strom berechneten Magnetfeldes dargestellt, während das untere Teilbild das Maximum des Barkhausenrauschens als Funktion der Härte (HRC) zeigt.

Wie aus Fig. 5 hervorgeht, wird die zunehmende Härte durch eine Abnahme der maximalen Barkhausenrauschamplitude wiedergegeben.

**Patentansprüche**

1. Verfahren zur zerstörungsfreien Ermittlung von Materialparametern von ferromagnetischen Werkstoffen eines Prüfkörpers (2) durch Auswertung des sog. Barkhausen-Effekts bzw. des sog. Barkhausen-Rauschens,
 **dadurch gekennzeichnet, daß** der Prüfkörper (2) mit einem zeitlich variierendem elektrischen Strom durchflutet wird, der so groß ist, daß das von dem Strom erzeugte zeitlich variable Magnetfeld die für den Barkhausen-Effekt notwendigen Ummagnetisierungsvorgänge erzeugt und daß eine momentane magnetische Feldstärke als Funktion eines momentanen elektrischen Stroms und der Prüfkörper - und Elektrodengeometrie berechnet wird.

2. Verfahren nach Anspruch 1,
 **dadurch gekennzeichnet, daß** der elektrische Strom und damit das Magnetfeld so große Werte erreichen, daß die Sättigungsmagnetisierung erreicht wird.

3. Verfahren nach Anspruch 1 oder 2,
 **dadurch gekennzeichnet, daß** der elektrische Strom zeitlich periodisch variiert und insbesondere ein Wechselstrom ist.

4. Verfahren nach einem der Ansprüche 1 bis 3,
 **dadurch gekennzeichnet, daß** der Barkhausen-Effekt im Rahmen anderer mit elektrischem Strom und insbesondere mit direktem Stromdurchgang arbeitender Meßverfahren gemessen wird.

5. Verfahren nach Anspruch 4,
 **dadurch gekennzeichnet, daß** das andere Meßverfahren die magnetische Oberflächenrißprüfung ist.

6. Vorrichtung zur zerstörungsfreien Ermittlung von . Materialparametern von ferromagnetischen Werkstoffen eines Prüfkörpers durch Auswertung des sog. Barkhausen-Effekts bzw. des sog. Barkhausen-Rauschens, insbesondere zur Durchführung des Verfahrens nach einem der Ansprüche 1 bis 6, mit einem Sensor (3) zur Aufnahme des Barkhausen-Rauschens,
 **dadurch gekennzeichnet, daß** zwei Elektroden (1) vorgesehen sind, zwischen denen durch den Prüfkörper (2) ein zeitlich variierender elektrischer Strom (I) fließt, der so groß ist, daß das von dem Strom erzeugte zeitlich variable Magnetfeld die für den Barkhausen-Effekt notwendigen Ummagnetisierungsvorgänge erzeugt und daß eine Elektrode (1) eine spitzenförmige Elektrode (1) und die andere Elektrode (1) eine spitzenförmige oder eine großflächige Elektrode (1) ist.

7. Vorrichtung nach Anspruch 6,
 **dadurch gekennzeichnet, daß** die beiden Elektroden (1) gleichartig ausgebildet sind und insbesondere den Prüfkörper (2) in etwa auf der gleichen Fläche berühren.

8. Vorrichtung nach Anspruch 6 oder 7,
 **dadurch gekennzeichnet, daß** die Geometrie der Elektrode(n) (1) der Geometrie des jeweiligen Prüfkörpers (2) und/oder dem Material des jeweiligen Prüfkörpers (2) angepaßt sind.

9. Vorrichtung nach einem der Ansprüche 6 bis 8,
 **dadurch gekennzeichnet, daß** eine Stromquelle die Elektroden stromeingeprägt mit einem Wechselstrom beaufschlagt.

10. Vorrichtung nach Anspruch 9,
 **dadurch gekennzeichnet, daß** die Frequenz des Stromes, d.h. die Erregerfrequenz, und/oder die Amplitude des Stromes regelbar sind.

11. Verwendung eines Verfahrens nach einem der Ansprüche 1 bis 5 bzw, einer Vorrichtung nach einem der Ansprüche 6 bis 10 zur Bestimmung der Eigenspannungen in Umfangsrichtung bei rotationssymmetrischen Prüfkörpern.

12. Verwendung eines Verfahrens nach einem der Ansprüche 1 bis 5 bzw, einer Vorrichtung nach einem der Ansprüche 6 bis 10 zur Barkhausen-Mikroskopie an dünnen, flächigen Prüfkörpern.

**Claims**

1. A process for nondestructive determination of the material parameters of ferromagnetic materials of a test piece (2) by means of evaluation of the so-called Barkhausen effect respectively the so-called Barkhausen noise,
**characterized by** the fact that said test piece (2) is flooded with a time-varying electric current which is so great that the periodic time-variable magnetic field generated by said current generates the reverse magnetization processes required for said Barkhausen effect and a momentary magnetic field strength is calculated as a function of the momentary electric current and of the test piece and electrode geometry.

2. A process according to claim 1,
**characterized by** the fact that said electric current and therefore said magnetic field attains such great values that saturation magnetization is effected.

3. A process according to claim 1 or 2,
**characterized by** the fact that said electric current varies periodically and, in particular, is an alternating current.

4. A process according to one of the claims 1 to 3,
**characterized by** the fact that said Barkhausen effect is measured as part of other measuring processes operating with electric current and, in particular, with direct current passage.

5. A process according to claim 4,
**characterized by** the fact that the other measuring process is magnetic surface crack testing.

6. A device for nondestructive determination of the material parameters of ferromagnetic materials of a test piece by means of evaluation of the so-called Barkhausen effect respectively the so-called Barkhausen noise, in particular for conducting the process according to one of the claims 1 to 6 using a sensor (3) for recording said Barkhausen noise,
**characterized by** the fact that two electrodes (1) are provided between which a time-variable electric current (I) flows through the test piece (3), said current being so great that the time-varying magnetic field generated by said current generates the reverse magnetization processes required for said Barkhausen effect, and that one said electrode is a pointed electrode and said other electrode is a pointed or a large-surface electrode.

7. A device according to claim 6,
**characterized by** the fact that said both electrodes (1) are designed in the same manner and, in particular, contact said test piece (2) on approximately the same sized area.

8. A device according to claim 6 or 7,
**characterized by** the fact that the geometry of said electrode(s) (1) is adapted to the geometry of the respective test piece (2) and/or the material of the respective test piece (2).

9. A device according to one of the claims 6 to 8,
**characterized by** the fact that a current source applies an alternating current to said electrodes.

10. A device according to claim 9,
**characterized by** the fact that the frequency of said current in the form of an excitation frequency and/or the amplitude of said current is regulatable.

11. Use of a process according to one of the claims 1 to 5 respectively of a device according to one of the claims 6 to 10 for determination of internal tensions in the circumferential direction in rotationally symmetrical test pieces.

12. Use of a process according to one of the claims 1 to 5 respectively of a device according to one of the claims 6 to 10 for Barkhausen microscopy of thin, plane test pieces.

**Revendications**

1. Procédé pour la détermination non destructive de paramètres de matériau sur des matières premières ferromagnétiques d'une éprouvette (2) par évaluation de l'effet ou du bruit dit Barkhausen,
**caractérisé en ce que** l'éprouvette (2) est traversée par un courant électrique variant dans le temps qui est si fort que le champ magnétique variable dans le temps qu'il génère produit les phénomènes d'inversion magnétique nécessaires pour l'effet Barkhausen et **en ce qu'**une intensité de champ, magnétique et momentanée, est calculée comme fonction d'un courant électrique momentané et de la géométrie de l'éprouvette et des électrodes.

2. Procédé selon la revendication 1,
**caractérisé en ce que** le courant électrique et par conséquent le champ magnétique, atteignent des valeurs tellement élevées qu'on parvient à la saturation magnétique.

**3.** Procédé selon la revendication 1 ou 2, **caractérisé en ce que** le courant électrique varie de manière périodique dans le temps et est notamment un courant alternatif.

**4.** Procédé selon l'une des revendications 1 à 3, **caractérisé en ce que** l'effet Barkhausen est mesuré dans le cadre d'autres procédés de mesure fonctionnant avec du courant électrique et notamment par traversée directe du courant.

**5.** Procédé selon la revendication 4, **caractérisé en ce que** l'autre procédé de mesure est l'essai magnétique des fissures superficielles.

**6.** Dispositif pour la détermination non destructive de paramètres de matériau sur des matières premières ferromagnétiques d'une éprouvette (2) par évaluation de l'effet ou du bruit dit de Barkhausen, notamment pour l'exécution du procédé selon l'une des revendications 1 à 6, avec un capteur (3) pour capter le bruit de Barkhausen, **caractérisé en ce que** sont prévues deux électrodes (1) entre lesquelles passe un courant électrique variant dans le temps qui traverse l'éprouvette (2) et qui est si fort que le champ magnétique variable dans le temps qu'il génère produit les phénomènes d'inversion magnétique nécessaires pour l'effet Barkhausen et **en ce qu'**une électrode (1) est une électrode pointue (1) et que l'autre électrode (1) est une électrode pointue ou à grande surface (1).

**7.** Dispositif selon la revendication 6, **caractérisé en ce que** les deux électrodes (1) sont de configuration similaire et font notamment contact avec l'éprouvette (2) sur à peu près la même surface.

**8.** Dispositif selon la revendication 6 ou 7, **caractérisé en ce que** la géométrie de la ou des électrodes (1) est adaptée à la géométrie de l'éprouvette (2) respective et/ou à son matériau.

**9.** Dispositif selon l'une des revendications 6 à 8, **caractérisé en ce qu'**une source de courant sollicite les électrodes par application d'un courant alternatif.

**10.** Dispositif selon la revendication 9, **caractérisé en ce que** la fréquence du courant, c'est-à-dire la fréquence d'excitation, et/ou l'amplitude du courant sont réglables.

**11.** Utilisation d'un procédé selon l'une des revendications 1 à 5 ou d'un dispositif selon l'une des revendications 6 à 10 pour déterminer les tensions naturelles en direction circonférentielle sur des éprouvettes à symétrie de révolution.

**12.** Utilisation d'un procédé selon l'une des revendications 1 à 5 ou d'un dispositif selon l'une des revendications 6 à 10 pour une microscopie Barkhausen sur des éprouvettes minces et planes.

FIG 1

FIG 2

## FIG 3A

## FIG 3B

I.)

31

1

Prüfteil

2

II.)

1

32      33

Prüfteil

2

III.)

1

33

2

Prüfteil

FIG 4